**Europäisches Patentamt**

**European Patent Office**

**Office européen des brevets**

(19)

(11) Veröffentlichungsnummer: **0 103 182**
**B1**

(12)

# EUROPÄISCHE PATENTSCHRIFT

(45) Veröffentlichungstag der Patentschrift:
**23.04.86**

(51) Int. Cl.⁴: **H 02 H 7/12,** G 01 R 31/02

(21) Anmeldenummer: **83107970.2**

(22) Anmeldetag: **11.08.83**

(54) **Einrichtung zur Überwachung der Stromrichterventile eines Wechselstromstellers.**

(30) Priorität: **13.08.82 JP 139805/82**

(43) Veröffentlichungstag der Anmeldung:
**21.03.84 Patentblatt 84/12**

(45) Bekanntmachung des Hinweises auf die Patenterteilung:
**23.04.86 Patentblatt 86/17**

(84) Benannte Vertragsstaaten:
**AT DE FR GB SE**

(56) Entgegenhaltungen:
**EP - A - 0 073 059**
**DE - A - 2 137 129**
**DE - A - 2 833 606**

(73) Patentinhaber: **FUJI ELECTRIC CO., LTD., 1-1,
Tanabeshinden, Kawasaki-ku, Kawasaki-shi
Kanagawa 210 (JP)**

(72) Erfinder: **Konishi, Shigeo, Toyoda-246-5 Hino-shi, Tokyo
(JP)**
Erfinder: **Shiraishi, Hirotaka, Tamadaira-3-11-8 Hino-shi,
Tokyo (JP)**

(74) Vertreter: **Mehl, Ernst, Dipl.-Ing. et al, Postfach 22 01 76,
D-8000 München 22 (DE)**

**Beschreibung**

Die Erfindung betrifft eine Einrichtung zur Überwachung der Stromrichterventile eines Wechselstromstellers, bei dem wenigstens zwei Schalteinheiten mit je einer Antiparallelschaltung von zwei Stromrichterventilen in Serie geschaltet sind, von denen in jeder Schalteinheit wenigstens eines steuerbar ist und wobei für jede Schalteinheit wenigstens ein Signalfühler vorgesehen ist, der ein von der an der Schalteinheit anliegenden Spannung abhängiges Signal bildet, das mittels einer Übertragungseinrichtung einer Auswertevorrichtung zugeführt ist.

Bei Serien-Parallelschaltungen von Thyristoren und Dioden in Wechselstromstellern, beispielsweise zum Ein- und Ausschalten von Kondensatorbatterien zur Blindleistungskompensation ist speziell für Kondensatoren großer Kapazität die Anzahl der Schaltelemente bzw. -einheiten stark angewachsen und Gegenspannungen sind zu beachten. Überwachungseinrichtungen für die Schaltelemente sind daher kompliziert und sehr teuer. Die Überwachungsvorrichtungen für den Wechselstromsteller, insbesondere für thyristorgeschaltete Kondensatorbatterien, müssen daher vereinfacht werden.

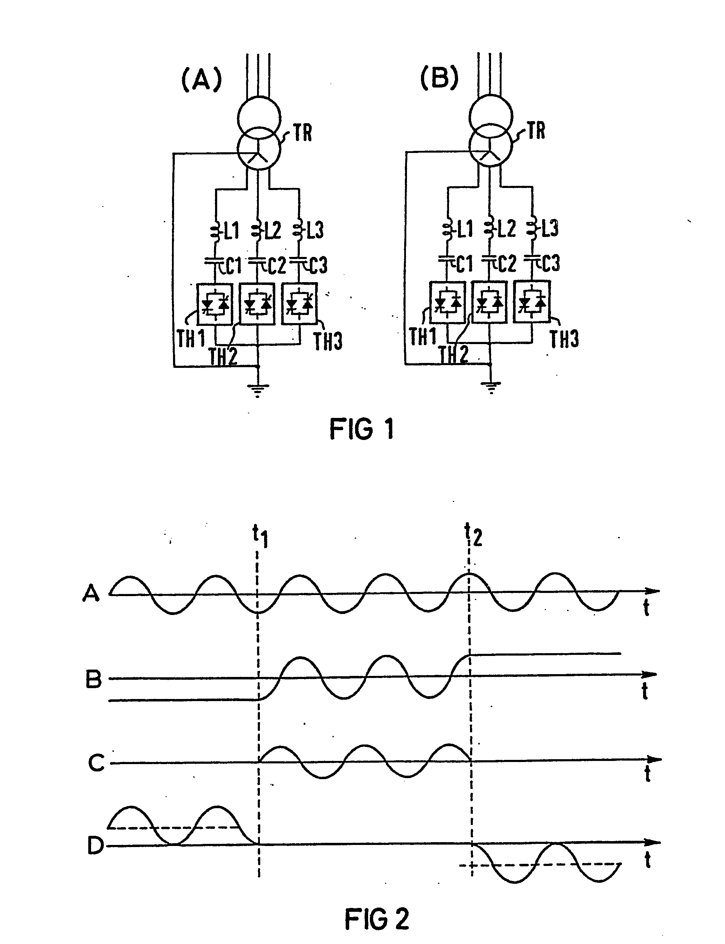

Wechselstromsteller für das Ein- und Ausschalten von Kondensatorbatterien sind im allgemeinen so aufgebaut, wie es in den Figuren 1 (A) un (B) gezeigt ist. Dabei sind in Figur 1 (A) die Wechselstromsteller THI bis TH3 jeweils in Serie mit Drosselspulen L1 bis L3 und Kondensatoren C1 bis C3 für jede Phase eines Dreiphasentransformators geschaltet, wobei die Schalter Thyristoren in Gegenparallelschaltung enthalten. In der Figur 1 (B) sind die Wechselstromsteller mit der Antiparallelschaltung jeweils eines Thyristors und einer Diode aufgebaut.

Im Betrieb auftretende Spannungen und Ströme sind in Figur 2 über der Zeit t aufgetragen, wobei das Signal A die Speisespannung, die Spannung B, die am Kondensator abfallende Spannung, das Signal C den Strom über den Kondensator und die Spannung D, die am Thyristorschalter abfallende Spannung ist. Dabei wird der Thyristorschalter zum Zeitpunkt $t_1$ eingeschaltet und zum Zeitpunkt $t_2$ abgeschaltet. Den Signalformen ist zu entnehmen, daß die am Thyristorschalter anliegende Spannung sich während der Ausschaltzeit aus der Spannung der Leistungsquelle und der Gleichspannung am Kondesator zusammensetzt.

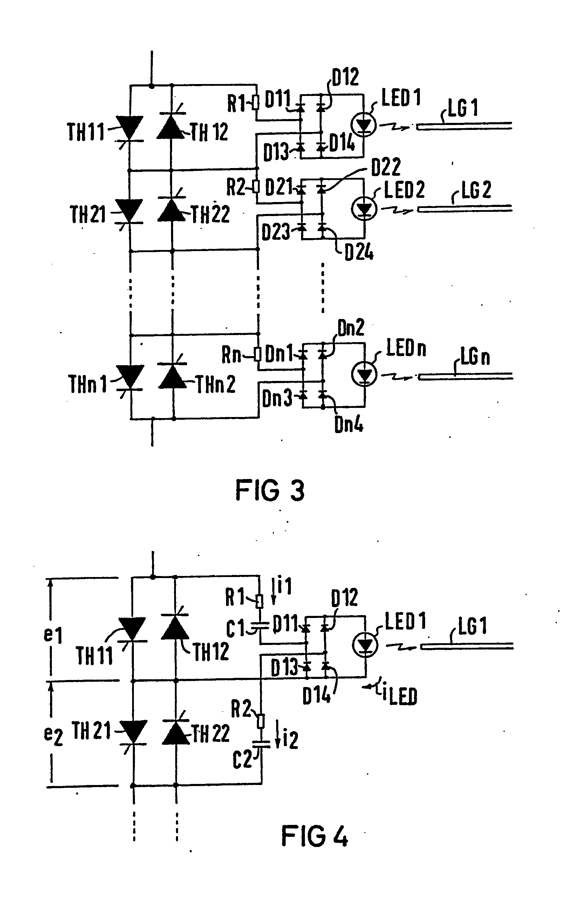

Figur 3 zeigt das Schaltbild einer handelsüblichen Überwachungsvorrichtung, für eine Vielzahl von in Serie geschalteten Schalteinheiten, wobei jede Schalteinheit eine Gegenparallelschaltung von Thyristoren besitzt. Mit dieser Überwachungsvorrichtung werden Fehler in Schaltelementen festgestellt, die, wie oben beschrieben, betrieben werden. Bei der Überwachungsvorrichtung wird jedes Stromrichterventil bzw. jeder Thyristor als fehlerfrei beurteilt, wenn an ihm im ausgeschalteten Zustand eine Spannung anliegt und es wird eine Betriebsstörung signalisiert, wenn in diesem Zustand an einem der Thyristoren keine Spannung ansteht. Hierzu wird die Spannung an den Widerständen R1 bis Rn überwacht, die von der Versorgungsspannung abhängt. Diese Spannung, beispielsweise die Spannung am Widerstand R1, wird mittels der Diodenbrücke D11 bis D14 gleichgerichtet und die Gleichspannung an eine lichtemittiererende Diode LED1 gelegt. Das Licht der Diode LED1 wird mittels einer Lichtleitung LG1 nach außen geführt. Da die Spannung, die an jedem der Thyristorschalter anliegt, wechselweise positiv oder negativ ist, wird mit der Vollweggleichrichtung der Diodenbrücke D11 bis D14 die anliegende Spannung für beide Polaritäten erhalten und angezeigt.

Bei der herkömmlichen Überwachungseinrichtung ist für jede Schalteinheit ein gesonderter Überwachungsschaltkreis erforderlich, so daß die Anzahl der Überwachungsschaltkreise der Anzahl der Schalteinheiten entspricht.

Außerdem ist auch für jeden der Überwachungsschaltkreise eine gesonderte Übertragungsleitung erforderlich, wobei diese Übertragungsleitungen elektrisch isoliert zur Auswertevorrichtung geführt werden müssen, die auf der Niederspannungsseite angeordnet ist. So hat man beim herkömmlichen Gerät beispielsweise die gleiche Anzahl von lichtemittierenden Dioden LED1 bis LEDn und die gleiche Anzahl von Lichtleitern LG1 bis LGn wie die Anzahl Schalteinheiten mit Stromrichterventilen in Gegenparallelschaltung. Dies kompliziert den Aufbau des Überwachungssystems sehr stark und erhöht die Kosten des Überwachungssystems, das eine hohe Spannungsfestigkeit besitzen muß, so daß es erheblich unwirtschaftlich ist.

Es besteht die Aufgabe, eine Überwachungsvorrichtung für Wechselstromsteller so auszugestalten, daß die Mängel des bekannten Systems vermieden werden, wobei ein einfacher Schaltungsaufbau und eine Realisierung mit geringen Kosten anzustreben ist.

Erfindungsgemäß wird diese Aufgabe dadurch gelöst, daß für die Signalfühler von zwei aufeinanderfolgenden Schalteinheiten ein gemeinsamer Signalgeber vorgesehen ist, der in aufeinanderfolgenden Halbwellen jeder Periode der Speisespannung für die eine oder die andere der beiden Schalteinrichtungen ein Signal abgibt, und daß das zusammengesetzte Signal über eine gemeinsame Übertragungsleitung übertragen wird.

Vorzugsweise ist jeder Signalfühler ein Differenzierglied.

Im folgenden wird die erfindungsgemäße Überwachungseinrichtung beispielhaft anhand der Figuren 4 bis 8 näher erläutert.

Figur 4 zeigt ein erstes Ausführungsbeispiel der erfindungsgemäßen Überwachungsschaltung. Das Ausführungsbeispiel zeigt zwei Schalteinheiten mit jeweils zwei antiparallelgeschalteten Thyristoren TH11 und TH12 bzw. TH21 und TH22. Wie angedeutet, können zu den beiden Schalteinheiten weitere Schalteinheiten in Serie geschaltet sein. Die Anoden-Kathodenspannung der Thyristoren TH11 und TH12 wird mittels eines Widerstandes R1 und eines Kondensators C1 und die Anoden-Kathodenspannung der Thyristoren TH21 und TH22 mittels eines Widerstandes R2 und eines Kondensators C2 erfaßt. Für das weitere sei angenommen, daß der Widerstandswert jedes der Widerstände R1 und R2 gleich R, die Kapazitätswerte jedes der Kondesatoren C1 und C2 gleich C sind und die Beziehung:

$$\frac{1}{2\,\pi\,f\cdot C} \gg R$$ zwischen dem Widerstand R und der Kapazität C gilt, worin f die Frequenz der anliegenden Wechselspannung ist. Unter dieser Voraussetzung ist die Größe des Stromes, der durch den Fühlerkreis fließt, im wesentlichen von der Kapazität C bestimmt. Der Strom entspricht damit etwa der differenzierten Anoden-Kathodenspannung der Thyristoren und der Widerstandswert R für jeden der Widerstände R1 und R2 ist so ausgelegt, daß der Einschaltstrom der Kondensatoren C1 und C2 genügend unterdrückt und verkleinert wird, den man beim Einschalten einer der Thyristoren erhält.

Jeweils einer der Anschlüsse der Serienschaltungen von R1 und C1 bzw. R2 und C2 ist mit dem Wechselstromanschluß der Diodenbrücke D11 bis D14 verbunden und eine lichtemittierende Diode LED1 ist zwischen die Gleichspannungsausgänge der Diodenbrücke geschaltet. Der Ausgang für die negative Gleichspannung der Diodenbrücke ist mit einem gemeinsamen Verbindungspunkt der Serienschaltung der Schalteinheiten verbunden.

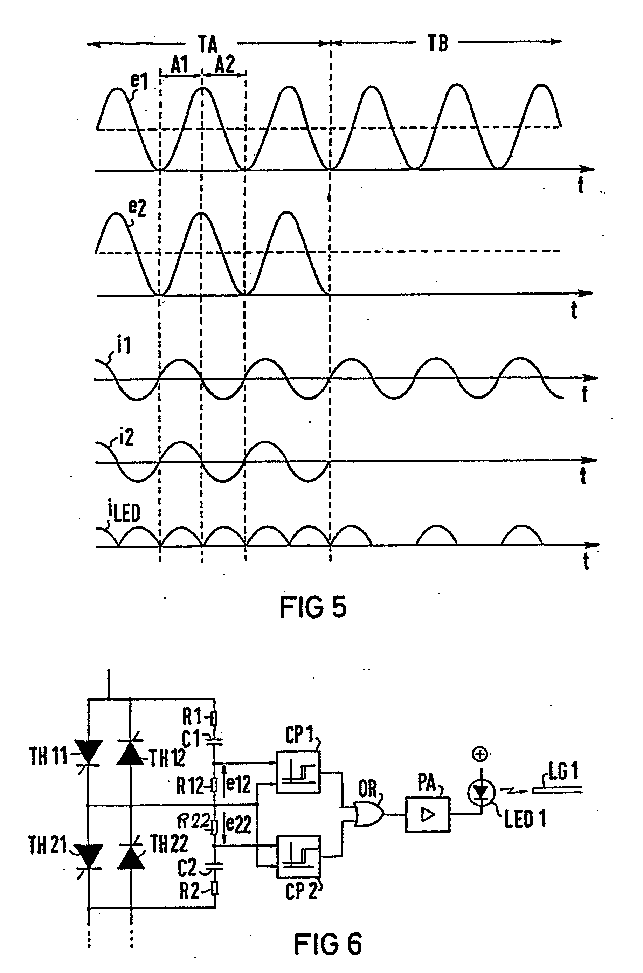

Figur 5 zeigt die Ströme und Spannungen, die für eine Einrichtung gemäß Figur 4 im Betrieb auftreten. Dabei tritt im Zeitabschnitt TA bei keinem der Thyristoren TH11, TH12, TH21 und TH22 eine Betriebsstörung auf. Der Zeitabschnitt TB zeigt Signalformen, die entstehen, wenn einer der Thyristoren TH21 oder TH22 wegen eines Kurzschlusses ausfällt. In Figur 5 ist die Spannung e1 der Thyristoren TH11 und TH12, die Spannung e2 der Thyristoren TH21 und TH22, der Strom i1, der durch den Serienkreis von R1 und C1 fließt und der Strom i2, der durch den Serienschaltkreis von R2 und C2 fließt, dargestellt.

Die Ströme i1 und i2 besitzen Signalformen, die angenähert gleich der differenzierten Wellenform der Schaltelementspannungen e1 und e2 sind. Der Strom i1 fließt in seiner positiven Halbwelle A1 über die Schaltelemente: R1 → C1 → D11 → LED1. Der Strom i2 fließt in seiner positiven Halbwelle über die Schaltelemente: D14 → R2 →. In seiner negativen Halbwelle A2 fließt der Strom i1 über die Schaltelemente: D13 → C1 → R1 und der Strom i2 über die Schaltelemente: C2 → R2 → D12 → LED1. Damit fließt wegen der Vollweggleichrichtung jeweils nur der Strom i1 im Zeitraum A1 und der Strom i2 im Zeitraum A2 durch die lichtemittierende Diode LED1. Das bedeutet, daß die Ströme i1 und i2 abwechselnd in einer der Halbwelle jeder Periode der Versorgungsspannung durch die lichtemittierende Diode LED1 fließen und das emittierte Licht mittels des gemeinsamen Lichtleiters LG1 einer Auswertevorrichtung übermittelt wird, die nicht gezeigt ist. Dabei kann eine Betriebsstörung in einem der Thyristoren TH11, TH12, TH21, und TH22 des Wechselstromstellers festgestellt werden. Der Zeitabschnitt TB zeigt den Fall, in dem einer der Thyristoren TH21 oder TH22 durch Kurzschluß in seinem Betrieb gestört ist. Außer den beim Betrieb auftretenden Signalformen der Figur 5 ist zu entnehmen, daß nur der Anteil des Stromes i1 aber nicht der Anteil des Stromes i2 durch die lichtemittierende Diode LED1 fließt. Damit kann der Fehler der Thyristoren TH21 oder TH22 mittels des emittierten Lichtes der lichtemittierenden Diode LED1 festgestellt werden.

Figur 6 zeigt ein anderes Ausführungsbeispiel der erfindungsgemäßen Überwachungseinrichtung. Im Schaltbild sind die Widerstände R12 und R22 Widerstände zur Erfassung des differenzierten Stromes oder der differenzierten Spannung, deren Form aus der Differentiation der Betriebsspannungen e1 und e2 der Schaltelemente resultiert. Ihr Widerstandswert $\overline{R}$ ist so gewählt, daß er der Beziehung:

$$\frac{1}{2\,\pi\,f\,C} \gg \overline{R}$$ genügt. Jeder der Widerstände R12 und R22 ist jeweils mit einer Vergleichsstufe CP1 bzw. CP2 verbunden, mit denen ein Signal abgegeben wird, wenn die Spannung e12 bzw. e22 einen bestimmten, vorgegebenen positiven Wert übersteigt.

Die Ausgänge der Vergleichsstufen CP1 und CP2 sind jeweils an Eingänge eines OR-Gatters OR geführt und das Ausgangssignal des Gatters OR wird mit einem Impulsverstärker PA verstärkt und dann der lichtemittierenden Diode LED1 zugeführt, die entsprechend Licht emittiert.

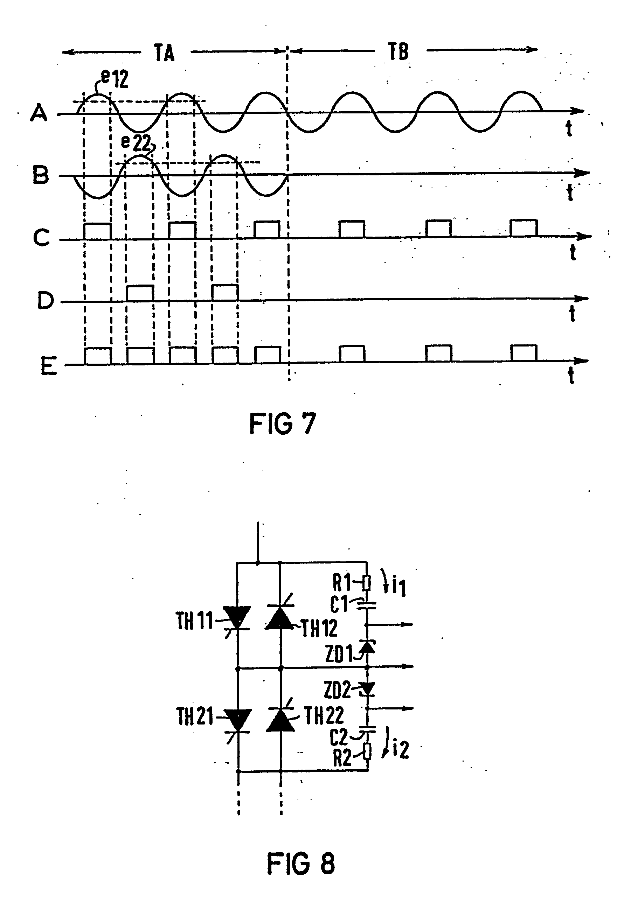

Figur 7 zeigt die Signalformen im Betriebszustand der Überwachungseinrichtung nach Figur 6. Dabei ist im Zeitraum TA ein Betriebszustand angenommen, in dem alle Thyristoren TH11, TH12, TH21 und TH22 einwandfrei arbeiten. In der Zeitspanne TB sind die Thyristoren TH21 oder TH22 gestört, beispielsweise wegen eines Kurzschlusses. Die Überwachungsspannungen e12 und e22 sind die Anschlußspannungen der Überwachungswiderstände R12 bzw. R22.

Diese Spannungen sind sinusförmig und um 180° gegeneinander phasenverschoben. Die Signale C und D sind die Ausgangsspannungen der Vergleichsstufen CP1 und CP2. Das Signal E zeigt die Ausgangsspannung des Gatters OR. Dem Diagramm ist zu entnehmen, daß die Impulse des Gatters OR in jeder Halbwelle, d.h. innerhalb von 180° el. jeder Periode der Versorgungsspannung auftreten. Dieses Ausgangssignal zeigt daher an, daß jeder der Thyristoren TH11, TH12 oder TH21 und TH22 normal arbeitet. Tritt ein Fehler in einer der Gegenparallelschaltungen von Thyristoren auf, so kann dieser mit dem Ausgangssignal erfaßt werden, das wechselweise in jeder Halbwelle der Versorgungsspannung erscheint. Ist beispielsweise einer oder beide Thyristoren TH21, TH22 kurzgeschlossen, so erhält man nur einen Impuls pro Periode, d.h. für 360° el. der Versorgungsspannung am Ausgang des Gatters OR, wie es in der Zeitspanne TB des Diagramms gezeigt ist. Dadurch läßt sich der Fehler erfassen.

Im Ausführungsbeispiel nach Figur 6 wird ein Signal mittels der Überwachungswiderstände R12 bzw. R22 erfaßt. Ein weiteres Ausführungsbeispiel der Überwachungseinrichtung zeigt Figur 8, wo ein Signal mittels der Z-Dioden ZD1 bzw. ZD2 erfaßt wird. Beim gezeigten Ausführungsbeispiel erhält man eine Ausgangs- bzw. Signalspannung, die der Z-Spannung der Z-Dioden entspricht, wenn in der einen Halbwelle der Versorgungsspannung der Strom i1 in Sperrichtung der Z- Diode ZD1 und in der anderen Halbwelle der gleichen Periode der Versorgungsspannung der Strom i2 in Sperrichtung der Z-Diode ZD 2 fließt.

Bei der erfindungsgemäßen Überwachungseinrichtung wird die Thyristorspannung für einen Wechselstromsteller mittels einer Wechselstromkomponente überwacht, die man vorzugsweise durch Differentiation der Spannung erhält, die an den Schalteinheiten des Wechselstromstellers abfällt. Dabei wird die positive oder negative Halbwelle einer Überwachungsspannung oder eines Überwachungsstromes wechselweise in jeder Periode der Versorgungsspannung als Überwachungssignal mittels einer gemeinsamen Überwachungsleitung übertragen. Diese Überwachungsspannung bzw. der Überwachungsstrom entspricht der Spannung an den Schaltelementen des Wechelstromstellers. Als besonders vorteilhaft zeigt sich, daß die Überwachungseinrichtung mit einer gemeinsamen Signalübertragung für zwei Schalteinheiten auskommt und daß die benötigte Anzahl der Überwachungsschaltkreise und der Signalübertragungsleitungen in Hinblick auf herkömmliche Systeme auf die Hälfte reduziert ist.

Die erfindungsgemäße Überwachungseinrichtung kann auch bei einer Vielzahl von in Serie geschalteten Schalteinheiten angewendet werden. Außerdem kann die Überwachungseinrichtung auch bei mehreren parallel geschalteten Stromrichterventilen, d.h. Thyristoren oder Dioden eingesetzt werden.

**Patentansprüche:**

1. Einrichtung zur Überwachung der Stromrichterventile (TH11, TH12, TH21, TH22) eines Wechselstromstellers, bei dem wenigstens zwei Schalteinheiten mit je einer Antiparallelschaltung von zwei Stromrichterventilen in Serie geschaltet sind, von denen in jeder Schalteinheit wenigstens eines steuerbar ist und wobei für jede Schalteinheit wenigstens ein Signalfühler (R1, C1; R2, C2) vorgesehen ist, der ein von der an der Schalteinheit anliegenden Spannung abhändiges Signal bildet, das mittels einer Übertragungseinrichtung einer Auswertevorrichtung zugeführt ist, dadurch gekennzeichnet, daß für die Signalfühler (R1, C1; R2, C2) von zwei aufeinanderfolgenden Schalteinheiten ein gemeinsamer Signalgeber (D11 bis D14; CP1, CP2; ZD1, ZD2) vorgesehen ist, der in aufeinanderfolgenden Halbwellen jeder Periode der Speisespannung für die eine oder die andere der beiden Schalteinrichtungen ein Signal abgibt, und daß das zusammengesetzte Signal über eine gemeinsame Übertragungsleitung (LG1) übertragen wird.

2. Einrichtung nach Anspruch 1, dadurch gekennzeichnet, daß jeder Signalfühler (R1, C1; R2, C2) ein Differenzierglied ist.

**Claims**

1. A device for monitoring the controlled rectifiers (TH11, TH12; TH21, TH22) of an alternating power converter, wherein at least two switching units are respectively connected in series with an anti-parallel circuit of two power converter-controlled rectifiers, at least one of which is controllable in each switching unit and where at least one signal sensor (R1, C1; R2, C2) is arranged for each switching unit, which signal sensor (R1, C1; R2, C2) forms a signal dependent upon the voltage connected to the switching unit and is fed to an analysing device by means of a transmission device, characterised in that a common signal generator (D11 to D14; CP1, CP2; ZD1, ZD2) is arranged to emit a signal in consecutive half-cycles of each period of the supply voltage for the one or the other of the two switching devices for the signal sensors (R1, C1; R2, C2) of two consecutive switching units, and that the combined signal is transmitted by means of a common transmission line (LG1).

2. A device as claimed in Claim 1, characterised in that each signal sensor (R1, C1; R2, C2) is a differentiating element.

**Revendications**

1. Dispositif pour contrôler les valves de conversion de courant (TH11, TH12, TH21, TH22) d'un régulateur de courant alternatif, dans lequel au moins deux unités de commutation sont branchées en série respectivement avec un montage antiparallèle de deux valves de convertion de courant, dont l'une au moins dans chaque unité de commutation peut être commandée, et dans lequel il est prévu pour chaque unité de commutation au moins un capteur de signaux (R1, C1; R2, C2) qui forme un signal dépendant de la tension appliquée à l'unité de commutation et qui est envoyé au moyen d'un dispositif de transmission à un dispositif d'exploitation, caractérisé par le fait que pour les capteurs de signaux (R1, C1; R2, C2) de deux unités de commutation successives il est prévu un générateur commun de signaux (D11 à D14; CP1, CP2; ZD1, ZD2), qui délivre un signal pendant des alternances successives de chaque période de la tension d'alimentation pour l'un ou l'autre des deux dispositifs de commutation, et que le signal composé est transmis par l'intermédiaire d'une ligne commune de transmission (LG1).

2. Dispositif suivant la revendication 1, caractérisé par le fait que chaque capteur de signaux (R1, C1; R2, C2) est un circuit différentiateur.

(A)                           (B)

TR                            TR

L1  L2  L3                    L1  L2  L3

C1  C2  C3                    C1  C2  C3

TH1        TH3               TH1          TH3
    TH2                          TH2

FIG 1

FIG 2

**FIG 3**

**FIG 4**

**FIG 5**

**FIG 6**

FIG 7

FIG 8